# EUROPÄISCHE PATENTSCHRIFT

(11) **EP 0 766 312 B1**
(45) Veröffentlichungstag und Bekanntmachung des Hinweises auf die Patenterteilung: **16.01.2002**
(21) Anmeldenummer: 96113008.5
(22) Anmeldetag: 13.08.1996
(51) Int. Cl.: H01L 27/108, H01L 27/06

(54) **Selbstverstärkende DRAM-Speicherzellenanordnung**
Gain cell DRAM storage device
Réseau de cellules à mémoire de type gain cell

(30) Priorität: 26.09.1995 DE 19535496
(43) Veröffentlichungstag der Anmeldung: 02.04.1997
(73) Patentinhaber: Infineon Technologies AG, 81669 München (DE)
(72) Erfinder: Krautschneider, Wolfgang, Dr., 83104 Hohenthann (DE)
(74) Vertreter: Reinhard - Skuhra - Weise & Partner

(56) Entgegenhaltungen:
- WO-A-92/01287
- US-A- 5 113 235
- 1995 SYMPOSIUM ON VLSI TECHNOLOGY DIGEST OF TECHNICAL PAPERS, 6.Juni 1995, Seiten 139-140, XP000580856 W. H. KRAUTSCHNEIDER ET AL.: "Planar Gain Cell for Low Voltage Operation and Gigabit Memories"
- MICROELECTRONIC ENGINEERING, Bd. 15, Nr. 1/4, Oktober 1991, AMSTERDAM NL, Seiten 367-370, XP000292780 W. H. KRAUTSCHNEIDER ET AL.: "Fully Scalable Gain Memory Cell for Future DRAMs"

## Beschreibung

Mit zunehmender Speicherdichte pro Chip von einer Speichergeneration zur nächsten ist die Fläche dynamischer Halbleiterspeicherzellen ständig verkleinert worden. Dazu sind ab der 4 Mbit-Speichergeneration dreidimensionale Strukturen erforderlich. Ab der 64 Mbit-Speichergeneration hat die Speicherkapazität einen Wert erreicht, der sich kaum noch reduzieren läßt, so daß eine ungefähr konstante Kapazität auf einer verkleinerten Zellfläche realisiert werden muß. Dies führt zu einem erheblichen technologischen Aufwand.

In Speicherzellen, bei denen die Signalladung nicht von einem Speicherkondensator, sondern von einer Versorgungsspannungsquelle geliefert wird, wird dagegen die Höhe der Signalladung nicht von der Größe der Speicherkapazität bestimmt. Bei diesen Speicherzellen ist es ausreichend, im Speicherkondensator nur eine kleinere Ladung zu speichern, die beim Auslesen der Speicherzelle ein Schaltelement so aktiviert, daß eine leitende Verbindung zwischen der Versorgungsspannungsquelle und der Bitleitung hergestellt wird. Derartige Speicherzellen werden als selbstverstärkende Speicherzellen oder Gain Memory Cells bezeichnet.

Eine derartige selbstverstärkende Speicherzelle ist zum Beispiel in M. Terauchi, A. Nitayama, F. Horiguchi und F. Masuoka, "A surrounding gate transistor (SGT) gain cell for ultra high density DRAMs", VLSI-Symp., Dig. Techn. Pap. p. 21, 1993, vorgeschlagen worden. Sie umfaßt einen eine Siliziumsäule umgebenden MOS-Transistor und einen darunter angeordneten Junction-Feldeffekttransistor. Der MOS-Transistor wirkt als Einschreibetransistor, während der Junction-FET als Auslesetransistor wirkt. Zum Auslesen und zum Einschreiben von Informationen sind in dieser Speicherzelle zwei getrennte Wortleitungen erforderlich, so daß zu jeder Speicherzelle zwei Wortleitungen vorgesehen sind.

In S. Shukuri, T. Kure, T. Kobayashi, Y. Gotoh und T. Nishida, "A semistatic complementary gain cell technology for sub-1 V supply DRAM's", IEEE Trans. Electron Dev., vol. 41, p. 926, 1994, ist eine selbstverstärkende Speicherzelle vorgeschlagen worden, die einen planaren MOS-Transistor und einen dazu komplementären, in einem Graben angeordneten Dünnfilmtransistor umfaßt. Der planare MOS-Transistor dient zum Einschreiben von Informationen, der Dünnfilmtransistor zum Auslesen von Informationen. Der Dünnfilmtransistor umfaßt ein floatendes Gate, das beim Einschreiben von Informationen mit Ladung beaufschlagt wird. Die Gateelektroden beider MOS-Transistoren sind mit einer Wortleitung verbunden. Sie werden mit unterschiedlicher Polarität angesteuert, so daß das Erzeugen und Schalten von Wortleitungsspannungen mit einem schaltungstechnischen Aufwand verbunden ist.

W.H. Krautschneider et al., Fully Scalable Gain Memory Cell for Future DRAMs, in Microelectronic Engineering 15 (1991), Seiten 367 - 370 und W. H. Krautschneider et al., Planar Gain Cell for Low Voltage Operation and Gigabit Memories, 1995 Symposium on VLSI Techn. Dig. of Techn. Papers, 6. Juni 95, Seiten 139 - 140 offenbaren selbstverstärkende DRAM-Zellen mit zwei planaren Transistoren und einer Schottky - Diode bzw. pn-Diode.

Aus WO 92/01287 ist eine selbstverstärkende dynamische MOS-Transistorspeicherzelle bekannt, die einen Auswahltransistor und einen Speichertransistor umfaßt. In dieser Speicherzelle wird die Ladung in der Gate/Source-Kapazität des Speichertransistors gespeichert. Die beiden Transistoren sind in Reihe geschaltet und weisen ein gemeinsames Drain/Source-Gebiet auf. Dieses gemeinsame Drain/Source-Gebiet ist über eine Diodenstruktur mit der Gateelektrode des Speichertransistors verbunden. Beim Auslesen wird der Speichertransistor je nach eingespeicherter Information eingeschaltet und schließt dadurch einen Strompfad von einer Versorgungsspannung zur Bitleitung. In diesem Zelltyp sind Auswahl- und Speichertransistor in Reihe geschaltet, so daß zum Auslesen des Signals keine spezielle Leitung erforderlich ist. Auswahltransistor und Speichertransistor können dabei sowohl als planare MOS-Transistoren als auch als in einem Graben angeordnete vertikale MOS-Transistoren realisiert werden. Gemäß einer Ausführungsform ist der Auswahltransistor als planarer MOS-Transistor und der Speichertransistor als vertikaler MOS-Transistor, der an der Flanke eines Grabens angeordnet ist, ausgebildet. Beide Transistoren sind über ein gemeinsames Drain/Source-Gebiet miteinander verbunden. Die Gateelektrode des Speichertransistors ist n⁺-dotiert und steht mit dem gemeinsamen Drain/Source-Gebiet, das n-dotiert ist, über eine p-dotierte Schicht und einen Strap, das heißt eine leitende Verbindung, in Verbindung. Gateelektrode und gemeinsames Drain/Source-Gebiet bilden dabei eine n⁺-p-Diode, in der die Information gespeichert wird. Der Kontakt zwischen der Gateelektrode des Speichertransistors und dem gemeinsamen Drain/Source-Gebiet ist an der planaren Oberfläche des gemeinsamen Drain/Source-Gebietes realisiert. Die n⁺-p-Diodenstruktur weist einen kleinflächigen Diodenkontakt auf, dessen Fläche mit abnehmender Strukturgröße des planaren Auswahltransistors weiter abnimmt.

Der Erfindung liegt das Problem zugrunde, eine DRAM-Zellenanordnung mit dynamischen selbstverstärkenden Speicherzellen anzugeben, die verbesserte elektrische Eigenschaften aufweist.

Dieses Problem wird erfindungsgemäß gelöst durch eine DRAM-Zellenanordnung gemäß Anspruch 1. Weitere Ausgestaltungen der Erfindung gehen aus den übrigen Unteransprüchen hervor.

Jede Speicherzelle der erfindungsgemäßen DRAM-Zellenanordnung umfaßt einen Auswahltransistor, der als planarer MOS-Transistor ausgebildet ist, und einen Speichertransistor, der als vertikaler MOS-Transistor ausgebildet ist. Der Auswahltransistor und der Speichertransistor sind über ein gemeinsames Source/Drain-Gebiet miteinander verbunden. Ein Source/Drain-Gebiet des Speichertransistors ist mit einer Versorgungsspannungsleitung verbunden. Ein Source/Drain-Gebiet des Auswahltransistors ist mit einer Bitleitung verbunden. Das mit der Versorgungsspannungsleitung verbundene Source/Drain-Gebiet des Speichertransistors wirkt als Drain-Gebiet, das mit der Bitleitung verbundene Source/Drain-Gebiet des Auswahltransistors wirkt als Source-Gebiet. Die Gateelektrode des Auswahltransistors ist mit einer Wortleitung verbunden. Der Speichertransistors weist eine Gateelektrode aus dotiertem Silizium auf, die entlang mindestens einer Flanke eines Grabens angeordnet ist. Im Graben ist ferner eine Siliziumstruktur angeordnet, die in bezug auf die Gateelektrode des Speichertransistors vom entgegengesetzten Leitfähigkeitstyp dotiert ist und die mit der Gateelektrode des Speichertransistors eine Diode bildet. Über einen Kontakt ist die dotierte Siliziumstruktur mit dem gemeinsamen Source/Drain-Gebiet verbunden. Der Diodenkontakt in der aus Gateelektrode des Speichertransistors und dotierter Siliziumstruktur gebildeten Diode erstreckt sich über die gesamte Oberfläche der Gateelektrode des Speichertransistors. Er ist damit unabhängig von der planaren Oberfläche des gemeinsamen Source/Drain-Gebietes.

Es liegt im Rahmen der Erfindung, die Gateelektrode des Speichertransistors und die Siliziumstruktur jeweils als Spacer auszubilden, die die Flanken des Grabens ringförmig auskleiden. Damit erstreckt sich der Diodenkontakt über die gesamte Seitenwandfläche des Grabens. Durch diese Maßnahme wird zusätzlich die Kapazität, in der die Information gespeichert ist, erhöht. Dadurch wird eine Verbesserung des Störverhaltens und eine Erhöhung der Haltezeit für die eingespeicherte Information erreicht.

Gemäß einer anderen Ausführungsform der Erfindung sind in dem Substrat eine Vielzahl von Längsgräben vorgesehen, die im wesentlichen parallel verlaufen. Die Speicherzellen sind matrixförmig so angeordnet, daß die Speichertransistoren entlang einer Zeile benachbarter Speicherzellen an gegenüberliegende Flanken der Längsgräben angrenzen. Jeweils zwei Auswahltransistoren entlang einer Zeile benachbarter Speicherzellen sind über ein gemeinsames Source/Drain-Gebiet miteinander verbunden, das mit einer gemeinsamen Bitleitung verbunden ist. Quer zu den Längsgräben sind Isolationsgräben vorgesehen, die entlang eines Längsgrabens benachbarte Speicherzellen gegeneinander isolieren. Die Isolationsgräben verlaufen jeweils zwischen benachbarten Zeilen von Speicherzellen. In dieser DRAM-Zellenanordnung wird eine erhöhte Packungsdichte dadurch erzielt, daß jeweils zwei Speichertransistoren an gegenüberliegenden Flanken der Längsgräben angrenzen und daß benachbarte Speicherzellen mit einer gesamen Bitleitung verbunden sind. Die Fläche des Diodenkontaktes wird in dieser Ausführungsform über die Tiefe der Längsgräben eingestellt.

Es liegt im Rahmen der Erfindung, zwischen der Gateelektrode des Speichertransistors und der dotierten Siliziumstruktur eine dielektrische Schicht vorzusehen, die eine Dotierstoffdiffusion zwischen der Gateelektrode und der Siliziumstruktur unterbindet. Die dielektrische Schicht kann zum Beispiel aus SiO₂ gebildet werden. Die dielektrische Schicht kann ferner aus nitridiertem Oxid gebildet werden, sie führt dann zusätzlich zu einer asymmetrischen Kennlinie der Diode, die für die Speichereigenschaften vorteilhaft ist.

Im Hinblick auf eine erhöhte Packungsdichte ist es vorteilhaft, den Kontakt zwischen der Siliziumstruktur und dem gemeinsamen Source/Drain-Gebiet durch eine Struktur aus Metallsilizid zu realisieren, die selbstjustiert zur Gateelektrode des Auswahltransistors herstellbar ist.

Im folgenden wird die Erfindung anhand der Figuren und der Ausführungsbeispiele näher erläutert.
- Figur 1: zeigt einen Schnitt durch eine dynamische selbstverstärkende Speicherzelle mit einem Speichertransistor, dessen Gateelektrode als Spacer ausgebildet ist und die Flanken eines Grabens ringförmig auskleidet.
- Figur 2: zeigt einen Schnitt entlang der linie A-A durch die in Figur 1 dargestellte selbstverstärkende Speicherzelle.
- Figur 3: zeigt einen Schnitt durch eine dynamische selbstverstärkende Speicherzelle mit einem Speichertransistor, der entlang einer Flanke eines Längsgrabens angeordnet ist.
- Figur 4: zeigt eine Aufsicht auf die in Figur 3 dargestellte selbstverstärkende Speicherzelle.

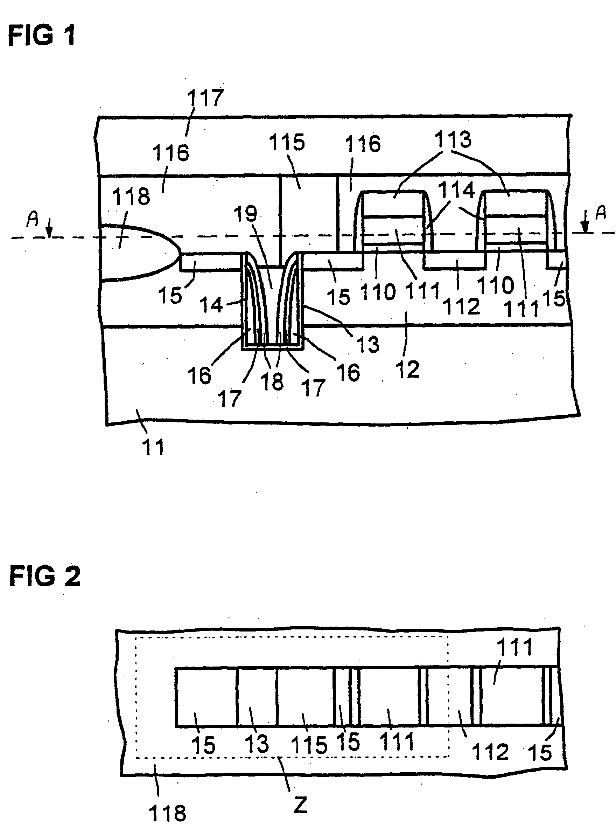

Ein Substrat 11 aus zum Beispiel n-dotiertem, monokristallinem Silizium umfaßt ein p-dotiertes Gebiet 12 (siehe Figur 1). Die Dotierstoffkonzentration in dem n-dotierten Substrat 11 beträgt zum Beispiel 10¹⁶ cm⁻³. Das p-dotierte Gebiet 12 ist zum Beispiel als p-dotierte Wanne mit einer Dotierstoffkonzentration von 5 x 10¹⁷ cm⁻³ oder als p-dotierte Epitaxieschicht mit einer Dotierstoffkonzentration von 10¹⁸ cm⁻³ realisiert. Das p-dotierte Gebiet 12 weist eine Tiefe von zum Beispiel 0.5 µm auf.

In dem Substrat 11 und im p-dotierten Gebiet 12 ist ein lochförmiger Graben 13 vorgesehen, der von der Oberfläche des p-dotierten Gebietes 12 bis in das Substrat 11 hineinreicht. Der Graben 13 weist eine Tiefe von zum Bespiel 1 µm und parallel zur Oberfläche Abmessungen von zum Beispiel 0.2 µm x 0.2 µm auf. Die Oberfläche des Grabens 13 ist mit einem ersten Gatedielektrikum 14, zum Beispiel thermischem Oxid in einer Dicke von 7nm, versehen. An der Oberfläche des p-dotierten Gebietes 12 ist ein ringförmiges n-dotiertes Gebiet 15 angeordnet, das den Graben 13 ringförmig umgibt. Entlang den Seitenwänden des Grabens 13 ist eine erste Gateelektrode 16 angeordnet, die den Graben 13 ringförmig umgibt. Die erste Gateelektrode 16 ist zum Beispiel aus n⁺-dotiertem Polysilizium in Form eines Spacers ausgebildet. Die erste Gateelektrode 16 weist eine Dotierstoffkonzentration von zum Beispiel 10²⁰ cm⁻³ auf.

Die Oberfläche der ersten Gateelektrode 16 ist mit einer dielektrischen Schicht 17 bedeckt. Die dielektrische Schicht 17 weist eine Dicke von 1 bis 2 nm auf und ist zum Bespiel aus thermischem Oxid gebildet.

An der Oberfläche der dielektrischen Schicht 17 ist eine Siliziumstruktur 18 angeordnet, die zum Beispiel aus p-dotiertem Polysilizium in Form eines Spacers gebildet ist. Die Siliziumstruktur 18 schließt mit der Oberfläche des n-dotierten Gebietes 15 im wesentlichen ab. Die p-dotierte Siliziumstruktur 18 weist eine Dotierstoffkonzentration im Bereich zwischen 5 x 10¹⁶ cm⁻³ und 5 x 10¹⁸ cm⁻³ auf. Die dotierte Siliziumstruktur 18 umgibt den Graben ebenfalls ringförmig. Die erste Gateelektrode 16 und die dotierte Siliziumstruktur 18 bilden eine Diode, in der eine Umdotierung zwischen der ersten Gateelektrode 16 und der dotierten Siliziumstruktur 18 durch die dazwischen angeordnete dielektrische Schicht 17 verhindert wird. In dem Graben 13 ist innerhalb der dotierten Siliziumstruktur 18 eine Isolationsstruktur 19 vorgesehen, die in der Höhe unterhalb der Oberfläche des n-dotierten Gebietes 15 abschließt, so daß am Rand des Grabens 13 die Oberfläche der dotierten Siliziumstruktur 18 von der Isolationsstruktur 19 unbedeckt ist. Die Isolationsstruktur 19 besteht zum Beispiel aus BPSG. Seitlich des Grabens 13 ist ein zweites Gatedielektrikum 110, eine zweite Gateelektrode 111 und ein weiteres n-dotiertes Gebiet 112 vorgesehen. Die zweite Gateelektrode 111 ist zum Beispiel aus n⁺-dotiertem Polysilizium gebildet. Die zweite Gateelektrode 111 ist mit einer Isolationsschicht 113 aus zum Beispiel SiO₂ bedeckt. Die Flanken der zweiten Gateelektrode 111 und der Isolationsschicht 113 sind mit isolierenden Spacern 114 bedeckt. Die isolierenden Spacer 114 sind zum Beispiel aus SiO₂ gebildet.

Der zwischen dem Graben 13 und der zweiten Gateelektrode 111 angeordnete Teil des n-dotierten Gebietes 15, das p-dotierte Gebiet 12, das zweite Gatedielektrikum 110, die zweite Gateelektrode 111 und das weitere n-dotierte Gebiet 112 bilden einen Auswahltransistor. Das n-dotierte Gebiet 15, das erste Gatedielektrikum 14, die erste Gateelektrode 16, das p-dotierte Gebiet 12 und das Substrat 11 bilden einen Speichertransistor. Der zwischen dem Graben 13 und der zweiten Gateelektrode 111 angeordnete Teil des n-dotierten Gebietes 15 bildet ein gemeinsames Source/Drain-Gebiet, über das der Speichertransistor und der Auswahltransistor in Reihe verschaltet sind. Die erste Gateelektrode 16 und die dotierte Siliziumstruktur 18 bilden eine Diode. Die dotierte Siliziumstruktur 18 ist über einen Kontakt 115, zum Beispiel aus Wolfram mit dem gemeinsamen Source/Drain-Gebiet elektrisch verbunden. Der Kontakt 115 ist zum Beispiel als mit Wolfram gefülltes Kontaktloch in einer ersten Zwischenoxidschicht 116, die die zweite Gateelektrode 111 und die Isolationsschicht 113 bedeckt, realisiert. Eine zweite Zwischenoxidschicht 117 bedeckt die Struktur. Der Speichertransistor und der Auswahltransistor bilden eine Speicherzelle.

In der DRAM-Zellenanordnung sind eine Vielzahl gleichartiger Speicherzellen matrixförmig angeordnet. Dabei schließt an die in Figur 1 dargestellte Speicherzelle eine spiegelsymmetrische Speicherzelle an, wobei das weitere n-dotierte Gebiet 112 beiden Speicherzellen angehört. In der DRAM-Zellenanordnung ist das weitere n-dotierte Gebiet 112 mit einer Bitleitung, die zweite Gateelektrode 111 mit einer Wortleitung und das Substrat 11 mit einer Versorgungsspannungsleitung verbunden. Zwei benachbarte Speicherzellen mit einem gemeinsamen weiteren n-dotierten Gebiet 112 sind zu den benachbarten Speicherzellen durch eine Isolationsstruktur 118 isoliert. Die Isolationsstruktur 118 ist zum Beispiel als LOCOS-Isolation oder Shallow Trench-Isolation ausgeführt. Sie grenzt an das n-dotierte Gebiet 15 und umgibt die beiden spiegelsymmetrischen Speicherzellen ringförmig (siehe Figur 2).

Zur Herstellung der Speicherzelle wird in dem n-dotierten Substrat 11 zur Bildung des p-dotierten Gebietes 12 durch Implantation eine p-dotierte Wanne oder auf das Substrat durch epitaktische Abscheidung eine p-dotierte Schicht aufgebracht. Durch maskierte Ätzung wird der Graben 13 gebildet. Durch thermische Oxidation wird das erste Gatedielektrikum 14 an der Oberfläche des Grabens 13 gebildet.

Durch Erzeugung einer n⁺-dotierten ersten Polysiliziumschicht durch in situ dotierte Abscheidung oder durch undotierte Abscheidung und anschließende Phosphordiffusion und anschließendes anisotropes Rückätzen der ersten Polysiliziumschicht wird an den Seitenwänden des Grabens 13 eine erste Gateelektrode 16 in Form eines Spacers gebildet. Dabei wird in planaren Bereichen die erste Polysiliziumschicht vollständig entfernt. Die erste Gateelektrode 16 schließt in der Höhe nicht mit dem Graben 13 ab. Die Flanken des Grabens 13 liegen oberhalb der ersten Gateelektrode 16 zum Beispiel 50 nm frei.

Durch thermische Oxidation der Oberfläche der ersten Gateelektrode 16 wird die dielektrische Schicht 17 gebildet. Anschließend wird eine zweite p-dotierte Polysiliziumschicht durch in situ dotierte Abscheidung oder durch undotierte Abscheidung und anschließende geneigte Implantation von Bor mit einem Neigungswinkel von 7 bis 25° erzeugt. Wird die zweite dotierte Polysiliziumschicht durch Implantation dotiert, so muß bei der Implantation die Grabenmaske noch vorhanden sein, um die Oberfläche abzuschirmen. Nach Aktivierung der Dotierstoffatome zum Beispiel mit Hilfe von RTA (rapid thermal annealing) wird durch anisotropes Rückätzen die zweite Polysiliziumschicht in planaren Bereichen entfernt und die dotierte Siliziumstruktur 18 in Form eines Spacers gebildet.

Durch Abscheidung einer Borphosphorglasschicht (BPSG) und Verfließen der Borphosphorglasschicht wird im Graben 13 die Isolationsstruktur 19 erzeugt.

Durch thermische Oxidation wird dann das zweite Gatedielektrikum 110 für den Auswahltransistor gebildet. Durch Abscheidung einer dritten Polysiliziumschicht und Serukturierung der dritten Polysiliziumschicht mit Hilfe photolithographischer Prozeßschritte wird die zweite Gateelektrode 111 gebildet. Die Isolationsschicht 113 wird durch Abscheidung einer SiO₂-Schicht und Strukturierung der SiO₂-Schicht gebildet. Die Strukturierung der SiO₂-Schicht und der dritten Polysiliziumschicht können dabei gleichzeitig erfolgen.

Durch Abscheidung einer SiO₂-Schicht und anisotroper Rückätzung der SiO₂-Schicht werden die isolierenden Spacer 114 an den Flanken der zweiten Gateelektrode 111 und der Isolationsschicht 113 gebildet. Durch maskierte Implantation werden das n-dotierte Gebiet 15 und das weitere n-dotierte Gebiet 112 gebildet.

Es wird die erste Zwischenoxidschicht 116 in einer Dicke von zum Beispiel 600 nm bis 800 nm abgeschieden. Nach Verfließen der ersten Zwischenoxidschicht 116 wird zur Bildung des Kontaktes 115 in der ersten Zwischenoxidschicht 116 ein Kontaktloch geöffnet und mit Wolfram aufgefüllt. Weist die Oberfläche des isolierenden Spacers 114 Siliziumnitrid auf oder besteht der isolierende Spacer 114 vollständig aus Siliziumnitrid, so kann die Öffnung des Kontaktloches selbstjustiert zu der zweiten Gateelektrode 111 erfolgen. Anschließend wird die zweite Zwischenoxidschicht 117 in einer Dicke von 400 nm bis 800 nm abgeschieden und durch Verfließen planarisiert.

Der Herstellungsvorgang wird abgeschlossen mit einer Kontaktlochätzung für den Bitleitungskontakt und einer Standardmetallisierung (nicht dargestellt).

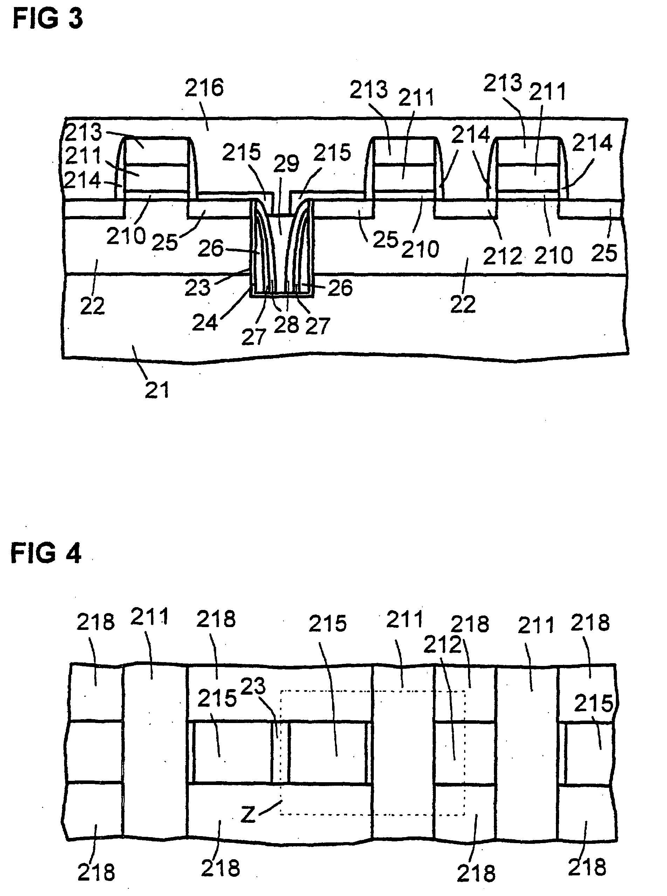

Ein Substrat 21 aus zum Beispiel n-dotiertem monokristallinem Silizium umfaßt ein p-dotiertes Gebiet 22 (siehe Figur 3). Das n-dotierte Substrat 21 weist eine Dotierstoffkonzentration von zum Beispiel 10¹⁶ cm⁻³ auf. Das p-dotierte Gebiet 22 weist eine Dotierstoffkonzentration von zum Beispiel 5 x 10¹⁷ cm⁻³ bis 5 x 10¹⁸ cm⁻³ auf. Das p-dotierte Gebiet 22 weist eine Tiefe von zum Beispiel 0,5 µm auf.

Das Substrat 21 umfaßt Längsgräben 23, die im wesentlichen parallel verlaufen, die eine Tiefe von zum Beispiel 1 µm aufweisen und die das p-dotierte Gebiet 22 in streifenförmige Gebiete unterteilen. Die Längsgräben 23 verlaufen über einen Block des Zellenfeldes und weisen eine Länge von zum Beispiel 80 µm und eine Breite von zum Beispiel 0.3 µm auf. Die Oberfläche der Längsgräben 23 ist mit einem ersten Gatedielektrikum 24, zum Beispiel SiO₂, bedeckt. An einer Flanke des Längsgrabens 23 ist eine erste Gateelektrode 26 aus zum Beispiel n⁺-dotiertem Polysilizium angeordnet. Die erste Gateelektrode 26 reicht vom Boden des Längsgrabens 23 bis zu einem definierten Abstand unterhalb der oberen Kante des Längsgrabens 23. Die Oberfläche der ersten Gateelektrode 26 ist mit einer dielektrischen Schicht 27, zum Beispiel aus thermischem Oxid oder nitridiertem Oxid in einer Dicke von 1 bis 2 nm, bedeckt. An der Oberfläche der dielektrischen Schicht 27 ist eine p-dotierte Siliziumstruktur 28 angeordnet, die vom Boden des Längsgrabens 23 bis an die Oberfläche des Substrats 21 mit dem p-dotierten Gebiet 22 reicht.

Seitlich der ersten Gateelektrode 26 ist in der Oberfläche des p-dotierten Gebietes 22 ein n-dotiertes Gebiet 25 und, seitlich versetzt, ein n⁺-dotiertes Gebiet 212 angeordnet. Das n-dotierte Gebiet 25 grenzt an die Flanke des Längsgrabens 23 an. Zwischen dem n-dotierten Gebiet 25 und dem n⁺-dotierten Gebiet 212 ist die Oberfläche des p-dotierten Gebietes 22 mit einem zweiten Gatedielektrikum 210 und einer zweiten Gateelektrode 211 versehen. Die zweite Gateelektrode 211 ist mit einer Isolationsschicht 213 zum Beispiel aus SiO₂ oder Si₃N₄ bedeckt. Die Flanken der zweiten Gateelektrode 211 und der Isolationsschicht 213 sind mit isolierenden Spacern 214 zum Beispiel aus SiO₂ oder Si₃N₄ bedeckt.

Der Längsgraben 23 ist mit einer Isolationsstruktur 29 aus zum Beispiel BPSG versehen. Die Isolationsstruktur 29 füllt den Längsgraben 23 nicht vollständig auf, so daß im oberen Bereich die Oberfläche der dotierten Siliziumstruktur 28 von der Isolationsstruktur 29 unbedeckt bleibt. An der Oberfläche des n-dotierten Gebietes 25 und der von der Isolationsstruktur 29 unbedeckten Oberfläche der dotierten Siliziumstruktur 28 ist ein Kontakt 215 angeordnet, der als Struktur aus Metallsilizid, zum Beispiel Titansilizid, realisiert ist.

Das n-dotierte Gebiet 25, das zweite Gatedielektrikum 210, die zweite Gateelektrode 211 und das n⁺-dotierte Gebiet 212 bilden einen Auswahltransistor. Das n-dotierte Gebiet 25, das erste Gatedielektrikum 24, die erste Gateelektrode 26 und das Substrat 21 bilden einen Speichertransistor. Das n-dotierte Gebiet 25 bildet ein gemeinsames Source/Drain-Gebiet für den Speichertransistor und den Auswahltransistor, über den diese in Serie verschaltet sind. Die erste Gateelektrode 26 und die dotierte Siliziumstruktur 28 bilden eine Diode. Die dotierte Siliziumstruktur 28 ist über den Kontakt 215 mit dem gemeinsamen Source/Drain-Gebiet 25 verbunden. Das n⁺-dotierte Gebiet 212 wird mit einer Bitleitung, die zweite Gateelektrode 211 mit einer Wortleitung und das Substrat 21 mit einer Versorgungsspannungsleitung verbunden. Die Verbindung des Substrats 21 mit der Versorgungsspannungsleitung erfolgt von der Rückseite her oder über einen vergrabenen Kontakt seitlich des Zellenfeldes.

In der DRAM-Zellenanordnung sind die Speicherzellen matrixartig in Zeilen und Spalten angeordnet. Entlang einer Zeile sind benachbarte Speicherzellen dabei jeweils spiegelsymmetrisch angeordnet. Dabei sind die Speichertransistoren von entlang einer Zeile benachbarter Speicherzellen an gegenüberliegenden Flanken ein- und desselben Längsgrabens 23 angeordnet. Die n⁺-Gebiete 212 der Auswahltransistoren von entlang einer Zeile benachbarter Speicherzellen stoßen aneinander und werden als ein gemeinsames n⁺-dotiertes Gebiet 212 realisiert. Entsprechend ist das gemeinsame n⁺-dotierte Gebiet 212 mit einer gemeinsamen Bitleitung verbunden.

Benachbarte Zeilen sind durch Isolationsgräben 218 gegeneinander isoliert (siehe Aufsicht in Figur 4). Die Isolationsgräben 218 sind so gestaltet, daß sie die n-dotierten Gebiete 25, die n⁺-dotierten Gebiete 212, die ersten Gateelektroden 26 und die dotierten Siliziumstrukturen 28 von entlang einer Spalte benachbarten Speicherzellen sicher trennen. Die Isolationsgräben 218 sind zum Beispiel als quer zu den Längsgräben 23 verlaufende Gräben, deren Tiefe mindestens der Tiefe der Längsgräben 23 entspricht und die mit isolierendem Material aufgefüllt sind, ausgebildet. Alternativ sind die Isolationsgräben 218 als quer zu den Längsgräben 23 verlaufende Gräben, deren Tiefe größer als die Tiefe der n-dotierten Gebiete 25 und der n⁺-dotierten Gebiete 212 ist, die jedoch nur bis in das p-dotierte Gebiet 22 hineinreichen und die mit isolierendem Material gefüllt sind, ausgebildet. Zusätzlich werden in diesem Fall die ersten Gateelektroden 26 und die dotierte Siliziumstruktur 28 entsprechend den Isolationsgräben 218 strukturiert, so daß die ersten Gateelektroden 26 und die dotierten Siliziumstrukturen 28 entlang einer Spalte benachbarter Speichertransistoren sicher getrennt sind.

Die DRAM-Zellenanordnung ist mit einer Zwischenoxidschicht 216 abgedeckt, auf der Bitleitungen, die über Bitleitungskontakte in der Zwischenoxidschicht 216 mit den n⁺-dotierten Gebieten 212 verbunden werden, angeordnet sind (nicht dargestellt).

Zur Herstellung der anhand von Figur 3 und Figur 4 erläuterten Speicherzellenanordnung wird in dem n-dotierten Substrat 21 das p-dotierte Gebiet durch Implantation als p-dotierte Wanne oder durch epitaktische Abscheidung einer p-dotierten Schicht erzeugt. Anschließend wird mit Hilfe photolithographischer Prozeßschritte eine Grabenmaske erzeugt. Es werden die Längsgräben 23 in einer Tiefe von 1 µm geätzt. Durch thermische Oxidation wird das erste Gatedielektrikum 24 an der Oberfläche der Längsgräben 23 gebildet.

Nachfolgend wird eine erste dotierte Polysiliziumschicht erzeugt, aus der durch Rückätzen die spacerförmige erste Gateelektrode aus n⁺-dotiertem Polysilizium gebildet wird. Die erste dotierte Polysiliziumschicht wird entweder in situ dotiert abgeschieden oder undotiert abgeschieden und anschließend durch Phosphordiffusion dotiert. Das Rückätzen wird solange fortgesetzt, bis die erste Gateelektrode 26 unterhalb der planaren Oberfläche des p-dotierten Gebietes 22 abschließt.

Die dielektrische Schicht 27 wird anschließend zum Beispiel durch thermische Oxidation in einer Dicke von 1 bis 2 nm erzeugt. Anschließend wird eine zweite dotierte Polysiliziumschicht erzeugt. Das erfolgt entweder durch in situ dotiertes Abscheiden oder durch undotiertes Abscheiden und anschließende Implantation von Bor mit einem Neigungswinkel von 7 bis 25°. Bei der Implantation muß die Grabenmaske noch vorhanden sein, um die planare Oberfläche abzuschirmen. Die Dotierstoffe werden anschließend mit Hilfe von RTA (rapid thermal annealing) aktiviert. Durch anisotropes Rückätzen wird aus der zweiten dotierten Polysiliziumschicht die dotierte Siliziumstruktur 28 als Spacer erzeugt.

Anschließend werden die Isolationsgräben 218 gebildet. Dazu wird mit Hilfe photolithographischer Prozeßschritte eine Maske erzeugt, die den Verlauf von Gräben quer zu den Längsgräben 23 definiert. Mit Hilfe dieser Maske wird die dotierte Polysiliziumstruktur 28, die bis zu diesem Prozeßschritt ein durchgehender Spacer für alle entlang einer Flanke eines Längsgrabens 23 benachbarten Speichertransistoren ausgebildet ist, in einem Trockenätzschritt strukturiert, bis die Oberfläche der dielektrischen Schicht 27 freigelegt ist. Anschließend wird mit Hilfe derselben Maske die dielektrische Schicht 27 trocken oder naßchemisch geätzt. Schließlich werden die ersten Gateelektroden 26 unter Verwendung derselben Maske in einem Trockenätzprozeß strukturiert. Zur Isolation der Auswahltransistoren wird quer zu den Längsgräben 23 ein Graben geätzt, der bis in das p-dotierte Gebiet 22 hineinreicht und die n-dotierten Gebiete 25 und n⁺-dotierten Gebiete 212 benachbarter Auswahltransistoren voneinander trennt und der mit abgeschiedenem SiO₂ aufgefüllt wird.

Alternativ werden zur Bildung der Isolationsgräben 218 streifenförmige Gräben geätzt, die quer zu den Längsgräben 23 verlaufen und die mindestens so tief wie die Längsgräben 23 sind. Diese Gräben werden durch Abscheidung einer Borphosphorsilikatglasschicht, die verflossen und anschließend zurückgeatzt wird, aufgefüllt. Dabei wird auch die Isolationsstruktur 29 zwischen an gegenüberliegenden Flanken eines Längsgrabens 23 angeordneten dotierten Siliziumstrukturen 28 gebildet.

Durch thermische Oxidation wird anschließend das zweite Gatedielektrikum 210 für die planaren Auswahltransistoren erzeugt.

Es wird eine dritte Polysiliziumschicht abgeschieden und mit Hilfe photolithographischer Prozeßschritte in einem Trokkenätzschritt zur Bildung der zweiten Gateelektrode 211 strukturiert. Die Oberfläche der zweiten Gateelektrode 211 wird mit der Isolationsschicht 213 versehen. An den Flanken werden durch Abscheidung einer SiO₂-Schicht und anisotropes Rückätzen isolierende Spacer 214 gebildet. Zur Bildung des Kontaktes 215 wird durch Abscheidung einer Metallschicht und einer nachfolgenden Silizierungsreaktion an der freiliegenden Oberfläche der dotierten Siliziumstruktur 28 und des n-dotierten Gebietes 25 selektiv die Struktur aus Metallsilizid erzeugt. An der Oberfläche der isolierenden Spacer 214, der Isolationsschicht 213 und der Isolationsstruktur 29 bildet sich dabei kein Silizid. Das nicht reagierte Metall wird in diesen Teilen nach der Silizierungsreaktion selektiv zum Metallsilizid entfernt. Anschließend wird die Zwischenoxidschicht 216 aus Borphosphorsilikatglas in einer Dicke von zum Beispiel 1000 nm abgeschieden. In dieser Ausführungsform wird nur eine Zwischenoxidschicht benötigt. Die Kontaktlochätzung zur Bildung des Kontaktes zwischen der dotierten Silizium-Struktur und dem n-dotierten Gebiet entfällt.

Die Herstellung der DRAM-Zellenanordnung wird abgeschlossen mit einer Kontaktlochätzung für den Bitleitungskontakt, Kontaktlochauffüllung sowie einer Standardmetallisierung.

## Patentansprüche

1. DRAM-Zellenanordnung,
- bei der in einem Substrat integriert eine Mehrzahl dynamischer selbstverstärkender Speicherzellen vorgesehen sind,
- bei der jede Speicherzelle einen Auswahltransistor, der als planarer MOS-Transistor ausgebildet ist, und einen Speichertransistor, der als vertikaler MOS-Transistor ausgebildet ist, umfaßt,
- bei der der Auswahltransistor und der Speichertransistor über ein gemeinsames Source/Drain-Gebiet (15,25) miteinander verbunden sind,
- bei der ein Source/Drain-Gebiet (11,21) des Speichertransistors mit einer Versorgungsspannungsleitung verbunden ist,
- bei der ein Source/Drain-Gebiet (112,212) des Auswahltransistors mit einer Bitleitung verbunden ist,
- bei der die Gateelektrode (111,211) des Auswahltransistors mit einer Wortleitung verbunden ist,
- bei der der Speichertransistor eine Gateelektrode (16,26) aus dotiertem Silizium vom ersten Leitfähigkeitstyp aufweist, die entlang mindestens einer Flanke eines Grabens (13,23) angeordnet ist,
**dadurch gekennzeichnet, daß**
- an den Flanken des Grabens (13,23) eine vom zweiten, dem ersten entgegengesetzten Leitfähigkeitstyp dotierte Siliziumstruktur (18,28) angeordnet ist, die mit der Gateelektrode (16,26) des Speichertransistors eine Diode bildet und die über einen Kontakt (115,215) mit dem gemeinsamen Source/Drain-Gebiet (15,25) verbunden ist.

2. DRAM-Zellenanordnung nach Anspruch 1,
bei der zwischen der Gateelektrode (16,26) des Speichertransistors und der Siliziumstruktur (18,28) eine dielektrische Schicht (17,27) angeordnet ist.

3. DRAM-Zellenanordnung nach Anspruch 1 oder 2,
bei der die Gateelektrode (16, 26) des Speichertransistors und die Siliziumstruktur (18, 28) jeweils als Spacer ausgebildet sind, die die Flanken des Grabens (13,23) auskleiden.

4. DRAM-Zellenanordnung nach Anspruch 1 oder 2,
- bei der in dem Substrat (21) eine Mehrzahl von Längsgräben (23) vorgesehen sind, die im wesentlichen parallel verlaufen,
- bei der die Speicherzellen matrixförmig so angeordnet sind, daß die Speichertransistoren benachbarter Speicherzellen an gegenüberliegende Flanken der Längsgräben (23) angrenzen und daß die Auswahltransistoren benachbarter Speicherzellen über ein gemeinsames Source/Drain-Gebiet (212) miteinander verbunden sind, das mit einer gemeinsamen Bitleitung verbunden ist,
- bei der quer zu den Längsgräben (23) Isolationsgräben (218) vorgesehen sind, die entlang eines Längsgrabens (23) benachbarte Speicherzellen gegeneinander isolieren.

5. DRAM-Zellenanordnung nach einem der Ansprüche 1 bis 4,
bei der der Kontakt (115) zwischen der Siliziumstruktur (18) und dem gemeinsamen Source/Drain-Gebiet (15) von Auswahltransistor und Speichertransistor durch ein mit einem hochschmelzenden Metall gefülltes Kontaktloch realisiert ist.

6. DRAM-Zellenanordnung nach einem der Ansprüche 1 bis 4,
bei der der Kontakt (215) zwischen der Siliziumstruktur (28) und dem gemeinsamen Source/Drain-Gebiet (25) von Auswahltransistor und Speichertransistor durch eine Struktur aus Metallsilizid realisiert ist.

## Claims

1. A DRAM cell arrangement,
- in which a plurality of dynamic gain memory cells are provided in an integrated fashion in a substrate,
- in which each memory cell comprises a selection transistor, formed as a planar MOS transistor, and a memory transistor, formed as a vertical MOS transistor,
- in which the selection transistor and the memory transistor are connected to one another via a common source/drain region (15, 25),
- in which a source/drain region (11, 21) of the memory transistor is connected to a supply voltage line,
- in which a source/drain region (112, 212) of the selection transistor is connected to a bit line,
- in which the gate electrode (111, 211) of the selection transistor is connected to a word line,
- in which the memory transistor has a gate electrode (16, 26) made of doped silicon of the first conductivity type, which is arranged along at least one sidewall of a trench (13, 23),
wherein
- a silicon structure (18, 28) doped by the second conductivity type, opposite to the first, is arranged on the sidewalls of the trench (13, 23), forms a diode with the gate electrode (16, 26) of the memory transistor and is connected to the common source/drain region (15, 25) via a contact (115, 215).

2. The DRAM cell arrangement as claimed in claim 1,
in which a dielectric layer (17, 27) is arranged between the gate electrode (16, 26) of the memory transistor and the silicon structure (18, 28).

3. The DRAM cell arrangement as claimed in claim 1 or 2,
in which the gate electrode (16, 26) of the memory transistor and the silicon structure (18, 28) are in each case formed as spacers which line the sidewalls of the trench (13, 23).

4. The DRAM cell arrangement as claimed in claim 1 or 2,
- in which a plurality of longitudinal trenches (23) running essentially parallel are provided in the substrate (21),
- in which the memory cells are arranged in a matrix-type manner such that the memory transistors of adjacent memory cells adjoin opposite sidewalls of the longitudinal trenches (23), and that the selection transistors of adjacent memory cells are connected to one another via a common source/drain region (212) connected to a common bit line,
- in which isolation trenches (218) are provided transversely with respect to the longitudinal trenches (23), adjacent memory cells along a longitudinal trench (23) being insulated from one another by said isolation trenches.

5. The DRAM cell arrangement as claimed in one of claims 1 to 4,
in which the contact (115) between the silicon structure (18) and the common source/drain region (15) of selection transistor and memory transistor is realized by a contact hole filled with a metal having a high melting point.

6. The DRAM cell arrangement as claimed in one of claims 1 to 4,
in which the contact (215) between the silicon structure (28) and the common source/drain region (25) of selection transistor and memory transistor is realized by a structure made of metal silicide.

## Revendications

1. Réseau de cellules de mémoire DRAM,
- dans lequel une pluralité de cellules de mémoire dynamique à auto-amplification, intégrées dans un substrat, sont prévues,
- dans lequel chaque cellule de mémoire comprend un transistor de sélection qui est réalisé comme un transistor planar MOS, et un transistor de mémoire qui est réalisé comme un transistor MOS vertical,
- dans lequel le transistor de sélection et le transistor de mémoire sont reliés l'un à l'autre par l'intermédiaire d'un domaine source-drain commun (15, 25),
- dans lequel un domaine source-drain (11, 21) du transistor de mémoire est relié à une ligne de tension d'alimentation,
- dans lequel un domaine source-drain (112, 212) du transistor de sélection est relié à une ligne de bits,
- dans lequel l'électrode (111, 211) de grille du transistor de sélection est reliée à une ligne de mots,
- dans lequel le transistor de mémoire présente une électrode (16, 26) de grille en silicium dopé du premier type de conductibilité qui est disposée le long d'au moins un flanc d'une rainure (13, 23),
**caractérisé en ce que** sur les flancs de la rainure (13, 23) une structure (18, 28) en silicium dopé du deuxième type de conductibilité, opposé au premier type, est disposée qui forme avec l'électrode (16, 26) de grille du transistor de mémoire une diode et qui est reliée par l'intermédiaire d'un contact (115, 215) au domaine source-drain commun (15, 25).

2. Réseau de cellules de mémoire DRAM selon la revendication 1, dans lequel une couche diélectrique (17, 27) est disposée entre l'électrode (16, 26) de grille du transistor de mémoire et la structure (18, 28) en silicium.

3. Réseau de cellules de mémoire DRAM selon la revendication 1 ou 2, dans lequel l'électrode (16, 26) de grille du transistor de mémoire et la structure (18, 28) en silicium sont constituées sous la forme de dispositifs d'espacement qui recouvrent les flancs de la rainure (13, 23).

4. Réseau de cellules de mémoire DRAM selon la revendication 1 ou 2,
- dans lequel une pluralité de rainures longitudinales (23) sont prévues dans le substrat (21) qui s'étendent de manière sensiblement parallèle,
- dans lequel les cellules de mémoire sont disposées en forme de matrice, de sorte que les transistors de mémoire de cellules voisines de mémoire sont limitrophes des flancs opposés des rainures longitudinales (23) et que les transistors de sélection de cellules voisines de mémoire sont reliés les uns aux autres par l'intermédiaire d'un domaine commun source-drain (212) qui est relié à une ligne commune de bits,
- dans lequel, transversalement aux rainures longitudinales (23), des rainures (218) d'isolation sont prévues qui isolent les unes des autres des cellules voisines de mémoire le long d'une rainure longitudinale (23).

5. Réseau de cellules de mémoire DRAM selon l'une des revendications 1 à 4, dans lequel le contact (115) entre la structure (18) en silicium et le domaine commun source-drain (15) du transistor de sélection et du transistor de mémoire est réalisé au moyen d'un trou de contact rempli avec un métal à point de fusion élevé.

6. Réseau de cellules de mémoire DRAM selon l'une des revendications 1 à 4, dans lequel le contact (215) entre la structure (28) en silicium et le domaine commun source-drain (25) du transistor de sélection et du transistor de mémoire est réalisé au moyen d'une structure en siliciure métallique.
